(19) Europäisches Patentamt
European Patent Office
Office européen des brevets

(11) Publication number: 0 353 818
A1

(12) EUROPEAN PATENT APPLICATION

(21) Application number: 89201965.4

(22) Date of filing: 26.07.89

(51) Int. Cl.⁴: H01L 21/312 , C23C 16/22 , G01N 27/00

(30) Priority: 29.07.88 IT 2155088

(43) Date of publication of application: 07.02.90 Bulletin 90/06

(84) Designated Contracting States: AT BE CH DE ES FR GB GR LI LU NL SE

(71) Applicant: ENIRICERCHE S.p.A.
Corso Venezia 16
I-20121 Milan(IT)

(72) Inventor: Barbarossa, Vincenzo
Via Amendola 9
I-00065 Fiano Romano Rome(IT)

(74) Representative: Roggero, Sergio et al
Ing. Barzanò & Zanardo Milano S.p.A. Via Borgonuovo 10
I-20121 Milano(IT)

# (54) Process for depositing organosilanes on substrates of silicon or silicon oxide for devices of EOS or CHEMFET type.

(57) A process for the deposition of organosilanes, in particular alkyl-siloxanes, on substrates of silicon or of silicon oxide for devices of EOS or CHEMFET type is disclosed, which is characterized in that said prccess is carried out by means of plasma-deposition.

Fig.1

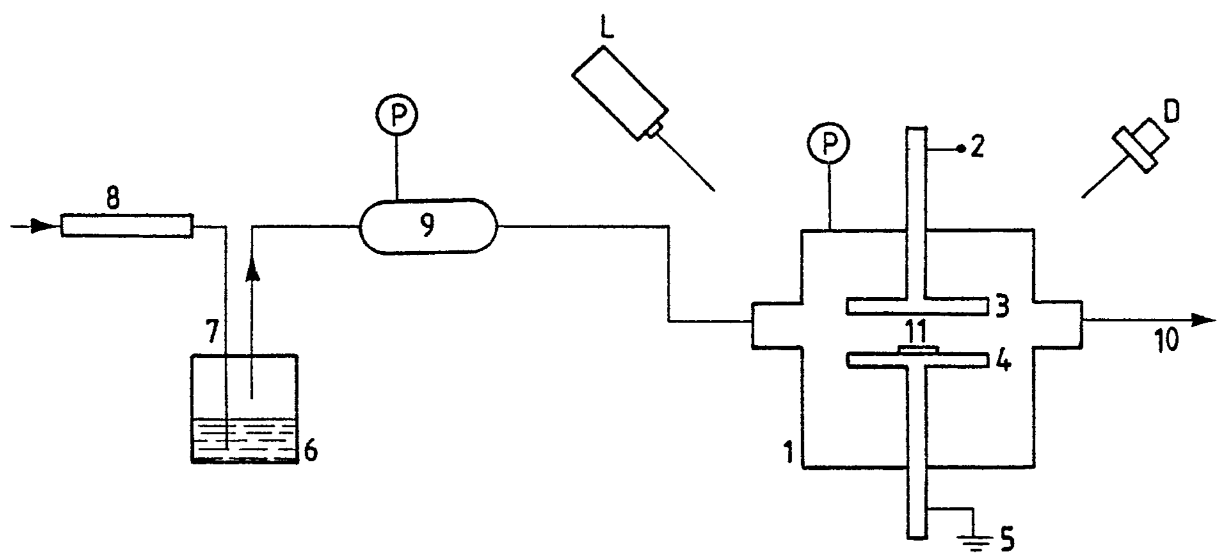


EP 0 353 818 A1

# PROCESS FOR DEPOSITING ORGANOSILANES ON SUBSTRATES OF SILICON OR SILICON OXIDE FOR DEVICES OF EOS OR CHEMFET TYPE

The present invention relates to a process for depositing organosilanes, in particular alkyl-siloxanes, on substrates of silicon or of silicon oxide on devices of EOS (Electrolyte oxide semiconductor) or CHEMFET type.

The organic compounds of silicon represent interesting starting molecules for the preparation of materials of technological interest.

To date, in many laboratories several materials obtained from organosilanes have been studied, the applications of which range from the preparation of membranes for reverse osmosis and membranes for gas separation, to biocompatible materials, and so forth. The general characteristic of these materials is their double nature, both organic and inorganic, which makes them particularly suitable for use in all those applications which require the interfacing of organic materials on inorganic matrices. Usually, for the applications on the devices of EOS or CHEMFET type, such organosilane compounds are deposited from the liquid phase and are then submitted to various types of "curing" (e.g., thermal curing, photochemical curing), carried out under mild conditions, in particular when the reactivity of particular chemical groups (e.g., amino groups) has to be preserved.

In the European Patatent Appln. Publ. Nr. 0270174 to the same Applicant, an ion-sensitive device is claimed, which is constituted by an organic polymeric matrix, an ionophore, a device of EOS or CHEMFET type containing on its surface silicon oxide adhering to the organic polymeric matrix by means of a polysiloxanic matrix, wherein the organic polymeric matrix is a linear polymethacryloyl chloride, and wherein the polysiloxanic matrix is selected from determined organosilanes.

The claimed process for obtaining said device also comprises the preparation of a siloxanic prepolymer, followed by one or more depositions thereof on a device of EOS or CHEMFET type and by a thermal treatment, by means of which a polysiloxanic matrix and the consequent chemical adhesion of said matrix to silicon oxide are obtained.

The deposition of the siloxanic prepolymer is carried out by means of techniques denominated as "spin-on" processes, which make it possible thicknesses not lower than 0.5 microns to be obtained.

The present Applicant has surprisingly found now that organosilanes can be deposited and polymerized on said devices by means of the plasma-decomposition method, with process conditions being selected, which make it possible the reactivity of the constituent groups to be preserved.

By means of the deposition process according to the present invention, the thickness of the organosilanic prepolymer can be reduced down to less than 0.5 microns, in that a more accurate control is made possible, and therefore an increase in the sensibility of the same device can be obtained.

In particular, by means of the plasma-deposition of, e.g., 3-aminopropyl-triethoxysilane (3-APTS), a polymeric material can be obtained, which is endowed with good mechanical and dielectric characteristics, and can be used in the manufacturing of chemical sensors of EOS or CHEMFET type.

The process for the deposition of organisilanes on substrates of silicon or silicon oxide of devices of EOS or CHEMFET type, according to the present invention, is characterized in that said deposition is carried out by plasma-deposition, preferably under the following deposition conditions:
- power comprised within the range of from 20 to 50 W;
- discharge pressure comprised within the range of from 0.1 to 1 torr;
- temperature comprised within the range of from room temperature to the temperature of decomposition of the used organosilane.

Among organosilanes, in particular the alkyl-siloxanes, and still more particularly, amino-alkyl-siloxanes, among which 3-aminopropyl-triethoxy-silane (3-ATPS), can be used.

## Example 1

Plasma-deposition of 3-aminopropyl-triethoxy-silane (3-ATPS) on surface-oxidated Si-substrates

Preparation

For the preparation of the material, the technique of plasma-deposition (or plasma-polymerization) was used, which consists in producing the species endowed with the necessary activity for the polymerization reaction, by means of the application of an R.F. electromagnetic field to the starting substance in the gas phase.

Under room conditions, 3-APTS is a colourless liquid having the following characteristics:

$$OCH_2CH_3$$
$$|$$
$$CH_3CH_2O-Si-CH_2CH_2CH_2NH_2$$
$$|$$
$$OCH_2CH_3$$

Molecular weight: 221.4
Boiling point : 223-224° C
density : 0.949

The material was deposited on surface-oxidated Si substrates.

The deposition system used is schematically shown in Figure 1.

The reactor (1) is a pyrex-glass cylinder of 18 cm of height and of 15 cm of diameter; the R.F. connection (2) is accomplished by means of two flat, mutually parallel electrodes (3) and (4) of stainless steel of 9 cm of diameter.

The upper electrode is connected to the power generator. which operates at the frequency of 2 MHz; the lower electrode is connected to ground (5) and also performs the function of supporting the substrates.

3-APTS gas is obtained by heating at 80° C the reserve (6), through which a carrier gas (argon) (7) is bubbled, with the carrier gas flow being controlled by means of the flowmeter (8). The Ar 3-APTS mixture flows firstly through the expansion chamber (9), which also performs the function of mixing said two gases, then comes to the reactor (1), and is finally pumped through (10).

Both the expansion chamber (9) and the reactor are provided with pressure gauges (P).

The substrate is indicated by means of the reference numeral (11).

The laser (L) and the photodetector (D) make it possible the measurement to be carried out "in_situ" of the thickness of the grown polymer, by means of the interferometric technique.

The following deposition conditions are adopted:

| | |
|---|---|
| - Power | : 20-25 W; |
| - Discharge pressure | : 0.2 torr; |
| - Depostion temperature | : 80° C; |
| - 3-ATPS flow rate | : 0.11-1.5 sccm (standard cc/minute); |
| - carrier gas | : argon. |

Characteristics of the material

The deposited material showed to have good electrical and mechanical characteristics, and to have a polymeric structure with reactive amino-groups.

In particular, the I.R. analysis shows the presence of aliphatic groups and of amino groups, as it can be observed from Figure 2, and from Table 1.

Figure 2 shows an IR-spectrum, wherein on the abscissa the wave number as $cm^{-1}$, and on the ordinate, the transmittance, as %, is reported.

From a mechanical viewpoint, the adhesion tests show that the material is well adhering onto the substrates of silicon or of silicon oxides.

From an electrical view point, the characterization carried out by means of capacity-voltage measurements in aqueous electrolytic solutions, supplied the value of the dielectric constant of the material, and made it possible the stability thereof to be evaluated. The C/V chart reported in Figure 3 was obtained by depositing the material on a slice of boron-doped silicon of P type having on its surface an $SiO_2$ layer of approximately 1,000 Å, with rear Au contacts. The measurement is carried out by keeping the surface of the

deposited material into contact with an electrolytic solution containing a Pt electrode.

From such a meaurement, it results that the plasma-deposition of 3-APTS did not damage to a detectable extent the layer of $SiO_2$, with the surface charge density resulting to be comprised within the range of from $10^9$ to $10^{11}$ $cm^{-2}$. By repeating this measurement one week later, one can observe that no changes have occured in the value of the maximum capacity, and therefore that in the deposited material no changes in thickness or in quality have occurred.

## Applications

The hereinabove disclosed process can be used in general in all those cases in which an inorganic layer has to be coupled with an organic layer which contains on its surface chemical groups capable of reacting with the amino group.

Table 1

| | Wave Number ($cm^{-1}$) | Vibrating Mode |
|---|---|---|
| 1 | 2960 | |
| 2 | 2930 | $\nu$s; $\nu$as: C-H in aliphatics |
| 3 | 2880 | |
| 4 | 1710-1660 | b: NH in $\overset{+}{N}H_3$ |
| 5 | 1465 | b: $-CH_3$ |
| 6 | 1420 | $b_{as}$: $CH_3$ in-Si-$CH_3$ |
| 7 | 1385 | b: $-CH_2-$ |
| 8 | 1270 | $\nu$: Si-$CH_3$ in-Si$(CH_3)_{1,2,3}$ |
| 9 | 1170 | $\nu$: Si-O-Si; Si-O-C; b:-N - H |
| 10 | 1100 | Si-O-Si |

## Claims

1. Process for the deposition of organosilanes, and, in particular, of alkyl-siloxanes, on substrates of silicon or silicon oxide of devices of EOS or CHEMFET type, characterized in that said deposition is carried out by plasma-deposition.

2. Process according to claim 1, wherein the plasma-deposition is carried out at a power comprised within the range of from 10 to 100 W, and under a discharge pressure comprised within the range of from 0.1 to 1 torr.

Fig.1

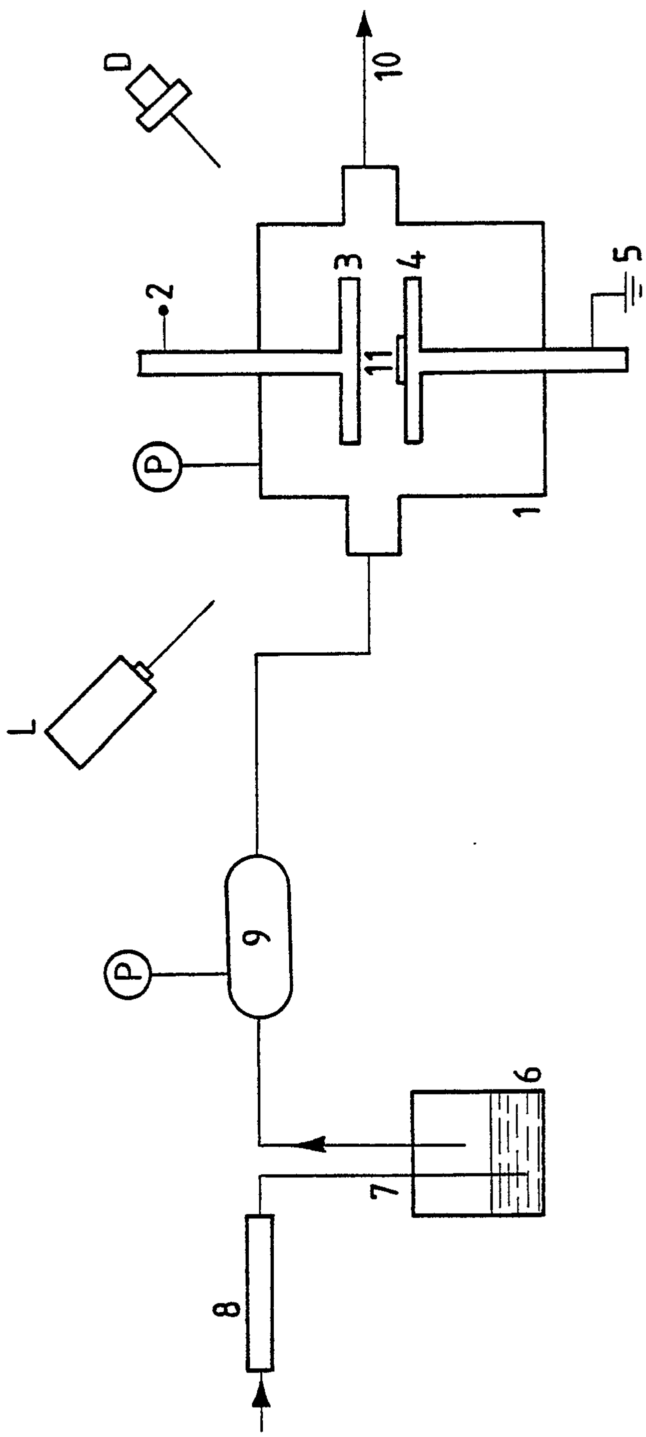

Fig.2

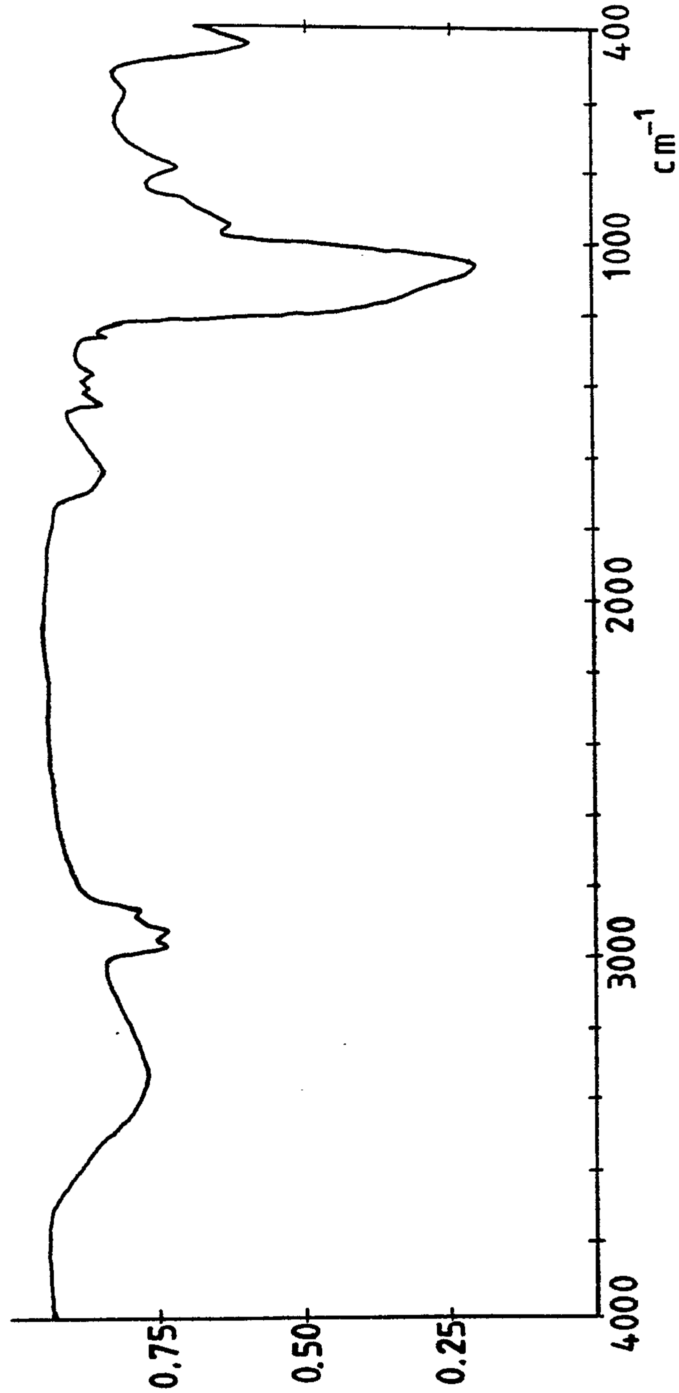

Fig.3

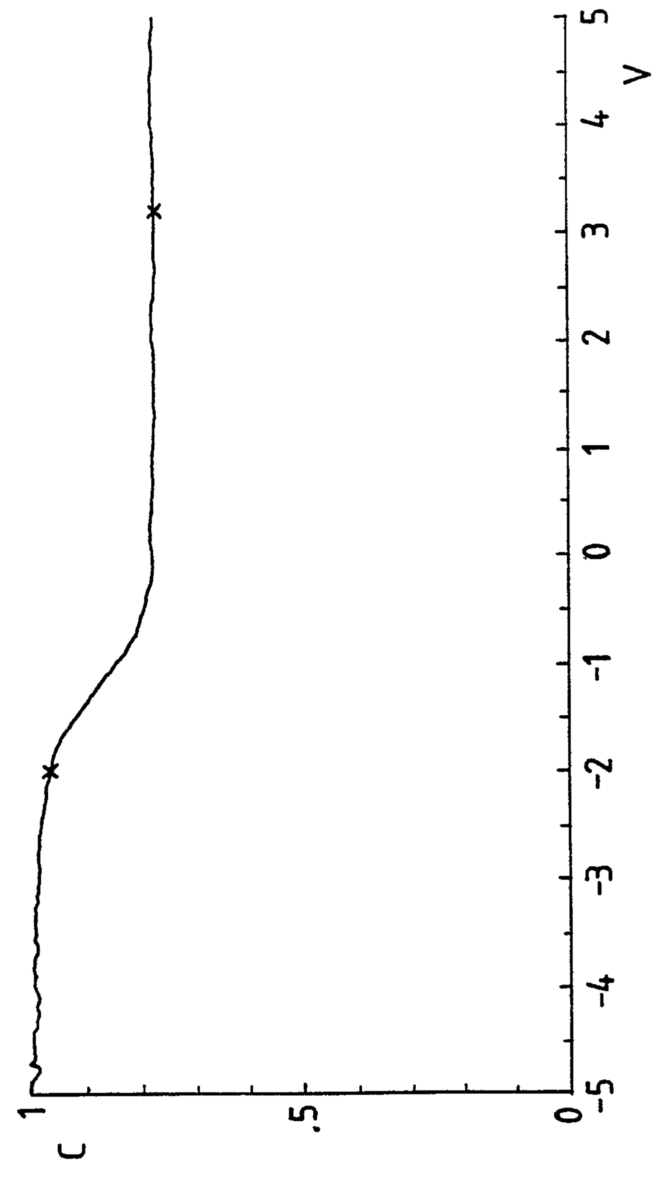

European Patent Office

# EUROPEAN SEARCH REPORT

Application Number

EP 89 20 1965

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 017 400 (KURARAY CO. LTD)<br>* Abstract; page 3, lines 39-54; page 4, lines 39-43; claims 11,13 *<br>--- | 1 | H 01 L 21/312<br>C 23 C 16/22<br>G 01 N 27/00 |
| Y | WO-A-8 700 633 (FRAUNHOFER-GESELLSCHAFT ZUR FÖRDERUNG DER ANGEWANDTEN FORSCHUNG E.V.)<br>* Page 9, line 28 - page 10, line 13; page 13, line 36 - page 14, line 6; page 17, lines 27-35; page 18, examples 1,2 *<br>--- | 1 | |
| Y | JOURNAL OF APPLIED PHYSICS, vol. 51, no. 9, September 1980, pages 5055-5057, American Institute of Physics, New York, US; M. AKTIK et al.: "A new polymer insulated gate field-effect transistor"<br>* Page 5055, column 1, lines 1-3 * | 1 | |
| A | IDEM<br>* Page 5056, column 2, lines 8-13 *<br>--- | 2 | TECHNICAL FIELDS SEARCHED (Int. Cl.5) |
| A | JOURNAL OF THE ELECTROCHEMICAL SOCIETY, vol. 132, no. 8, August 1985, pages 1925-1932, Manchester, New Hampshire, US; V.S. NGUYEN et al.: "Plasma organosilicon polymers"<br>* Page 1925, column 2, lines 5-13; page 1925, column 2, tables 1,2 *<br>--- | 1,2 | H 01 L<br>C 23 C<br>G 01 N |
| A | GB-A-2 125 423 (WESTERN ELECTRIC CO. INC.)<br>* Abstract; page 1, lines 75-83; page 2, lines 64-83 *<br>--- -/- | 1,2 | |

The present search report has been drawn up for all claims

| Place of search | Date of completion of the search | Examiner |
|---|---|---|
| THE HAGUE | 06-11-1989 | JOFFREAU P.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent Office

# EUROPEAN SEARCH REPORT

Application Number

EP 89 20 1965

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 9, no. 4 (E-288)[1727], 10th January 1985; & JP-A-59 154 029 (NIPPON DENSHIN DENWA KOSHA) 03-09-1984<br>* Abstract *<br>----- | 1,2 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 06-11-1989 | JOFFREAU P.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document